# EUROPEAN PATENT APPLICATION

(11) **EP 2 528 092 A1**
(43) Date of publication of application: **28.11.2012**
(21) Application number: 11167810.8
(22) Date of filing: 27.05.2011
(51) Int. Cl.: H01L 23/62, H01L 25/07, H01L 21/60

(54) **Semiconductor device**

(71) Applicant: ABB Research Ltd., 8050 Zürich (CH)
(72) Inventor: Kicin, Slavo, 8049 Zürich (CH); Schulz, Nicola, 5300 Turgi (CH); Häfner, Jürgen, 77142 Ludvika (SE); Liu, Chunlei, 5443 Niederrohrdorf (CH); Hamidi, Amina, 5404 Baden (CH); Fabian, Jan-Henning, 5507 Mellingen (CH)
(74) Representative: ABB Patent Attorneys

(57) **Abstract**

A semiconductor device (509a, b) comprises a semiconductor chip (504a, b) comprising a bottom electrode and a top electrode and a bottom electrode-baseplate (502). The bottom electrode-baseplate (502) is electrically and thermally conductive. The semiconductor device (509a, b) comprises a top electrode-baseplate (508). The top electrode-baseplate (508) is electrically and thermally conductive. The semiconductor device (509a, b) comprises a first preform (506a, b) made of material configured for supporting a creation of an electrically conductive alloy when being melted. In order to provide a semiconductor device having enhanced characteristics, the bottom electrode of the semiconductor chip (504a, b) is thermally and electrically connected to the bottom electrode-baseplate (502) via a first bonding layer (618), the top electrode of the semiconductor chip (504a, b) is thermally and electrically connected to a first side of the first preform (506a, b) via a second bonding layer (620), and the second side of the first preform (506a, b) is thermally and electrically connected to the top electrode-baseplate (508) via a third bonding layer (624).

## Description

### Technical Field

The invention relates to the area of high power applications, and in particularly to a semiconductor device, an electronic power apparatus, and a method of manufacturing a semiconductor device.

### Background Art

An electronic power apparatus comprises one or more (high power) semiconductor devices which may be connected in series or in parallel to one another. Usually, semiconductor chips of the semiconductor devices may comprise switching functionality, and may be configured as transistors or diodes. Failure of one or more of the semiconductor devices during operation may represent an important issue regarding manufacturing, maintenance and/or retrofitting applications.

For example, power modules (particularly insulated gate bipolar transistor (IGBT) modules) with an internal short circuit failure mode SCFM capability are important components of voltage source converters (VSC) usable in a power transmission area. SCFM capability means that the semiconductor chips (modules) fail not with an open circuit, but a short circuit. The semiconductor chips are not able to switch any more. However, the semiconductor chips still carry a load current at least for certain time. There is designed redundancy in the system, and the other modules are able to share the blocking voltage since a failed module has now only a function of a resistor. The converters than usually require only regular- planned maintenance to change the failed modules.

One of the possible solutions (and a current solution of the applicant) for the internal SCFM capability is based on melting of materials due to dissipation of energy induced by the failure. A silicon chip and a suitable metal part attached to an emitter contact of the semiconductor chip (for example, aluminum (Al), silver (Ag) - these materials must create an eutectic alloy with silicon with sufficiently low melting temperature) melt and create an electrically highly conductive alloy - a so called "hot spot". Such a built-in solution has been applied in press-pack power module concepts - a so called StakPak (see for example, EP 0 989 611 A2 or B1, US 6,426,561 B1, US 7,538,436 B2 the content of which will be detailed later). The collector side of semiconductor chips is soldered to the substrate. For example, an aluminum piece (a component to be melt to form a conductive channel through the chip) and the molybdenum piece (a component compensating a coefficient of thermal expansion (CTE) mismatch) are stacked on the emitter side of the chip. A mechanical component (a spring) is used to apply pressure necessary for a dry contact of a good quality. Here, the term "dry contact" may particularly denote a pressure based contact interface between the semiconductor chip and components arranged adjacent to the semiconductor chip. The spring concept also protects chips against mechanical damage allowing homogeneous distribution of pressure between chips and allows compensating height changes caused by short circuit failure.

S. Gunturi et al., "Innovative Metal System for IGBT Press Packs", presented at ISPSD 2003, describes a spring-loaded press pack package comprising SCFM capability. A respective package comprises a baseplate on which a silicon-based chip is soldered. A platelet is arranged on an upper side of the silicon chip, and is pressed by a spring loaded pin towards the semiconductor chip. In case of an electronic failure, the material of the semiconductor chip and the material of the platelet are heated such that an eutectic metallic alloy is formed which provides a short circuit path over the semiconductor chip.

EP 0 989 611 A2 or B1 or US 6,426,561 B1 describes a pressure-based IGBT module comprising a plurality of semiconductor chips connected in parallel to one another and being sandwiched between a conductive substrate and respective pistons. A layer made of a material such as aluminum, silver, gold, copper, or magnesium is arranged in contact with the semiconductor chip, and is arranged between the substrate and a respective one of the pistons. Upon heating, the layer together with the semiconductor material of the semiconductor chip form an eutectic mixture, and thus form a metallically conductive channel over the semiconductor chip.

US 7,538,436 B2 describes a high-power press-pack semiconductor module comprising a plurality of semiconductor chips sandwiched between a conductive base plate and a conductive top plate. A contact piston presses the top plate and a respective one of the semiconductor chips against the base plate. The material of the top plate and the base plate is made of a metal matrix composite material whose value of a coefficient of thermal expansion is adaptable to a value either close to or matching a value of the coefficient of thermal expansion of the material of the semiconductor chip.

Typical problems relevant for the described device or StakPak module are aging of dry electrical contacts (for example, due to a penetration of silicone gel which may cover the semiconductor chips), a resistance of a current path ((particularly owing to) many interfaces (particularly between respective components)), a complexity of (particularly an arrangement of the) mechanical components, a limitation of current load by the spring shape, and costs. Recently there has been also started a discussion about possible limits of current and voltage rating in the future.

### Summary of invention

It is an object of the present invention to provide a semiconductor device or module and an electronic power apparatus having improved characteristics. Further, it is an object of the present invention to provide a method of manufacturing such a semiconductor device and such an electronic power apparatus.

According to an exemplary aspect of the invention, a semiconductor device is provided, the semiconductor device comprising a semiconductor chip comprising a bottom electrode and a top electrode, a bottom electrode-baseplate, wherein the bottom electrode-baseplate is electrically and thermally conductive, a top electrode-baseplate, wherein the top electrode-baseplate is electrically and thermally conductive, and a first preform made of material configured for supporting a creation of an electrically conductive alloy (particularly with a material of the semiconductor chip) when being melted, wherein the bottom electrode of the semiconductor chip is thermally and electrically connected to the bottom electrode-baseplate via a first bonding layer, wherein the top electrode of the semiconductor chip is thermally and electrically connected to a first side of the first preform via a second bonding layer, and wherein the second side of the first preform is thermally and electrically connected to the top electrode-baseplate via a third bonding layer.

According to another exemplary aspect of the invention, an electronic power apparatus is provided, the electronic power apparatus comprising a semiconductor device as described above.

According to another exemplary aspect of the invention, a method of manufacturing a semiconductor device is provided, the method comprising providing a semiconductor chip comprising a bottom electrode and a top electrode, providing a bottom electrode-baseplate, wherein the bottom electrode-baseplate is electrically and thermally conductive, providing a top electrode-baseplate, wherein the top electrode-baseplate is electrically and thermally conductive, providing a first preform made of material configured for supporting a creation of an electrically conductive alloy (particularly with a material of the semiconductor chip) when being melted, preparing a stack of the bottom electrode-baseplate, the semiconductor chip, and the first preform by bonding (particularly by sintering), and bonding the top electrode-baseplate to the stack (particularly by soldering).

In the context of the present application, the term "semiconductor device" may particularly denote an arrangement which may comprise at least one semiconductor based component, for example a diode or a transistor. In particular, the term "semiconductor device" and the term "module" may be used in the present application in an exchangeable way.

The term "semiconductor chip" may particularly denote a semiconductor material based functional component. For example, such a functionality may refer to switching a current.

The term "preform" may particularly denote a parison or a workpiece which may particularly comprise or be configured as a platelet.

The terms "top and bottom elements" and "upper and lower sides" may particularly denote a relative arrangement of first and second elements or of first and second sides to one another, and may not imply any direction or any arrangement relative to a ground level.

The term "side" of an element may particularly denote a (two dimensional) surface or (three dimensional) surface layer portion of the element.

The term "a first element is connected to a second element via a third element" may refer to a direct or indirect connection (particularly via further elements) between the first, second, and third elements.

The term "bonding" may particularly denote a technique for joining elements to one another, and may particularly comprise sintering, soldering, brazing, and diffusion bonding.

The terms detailed in the section "Background Art" may particularly apply to a description of the present invention.

The terms "element" and "component" may be used in an exchangeable way.

According to the exemplary aspects of the invention, the manufactured semiconductor device may comprise a sandwiched stack formed by the bottom electrode-baseplate, the semiconductor chip, the first preform, and the top electrode-baseplate. Each component of the semiconductor device may be connected to one another by respective bonding layers formed by bonding (particularly by sintering or soldering).

Accordingly, the semiconductor device may comprise a high reliability under normal operation conditions particularly in comparison to pressure based semiconductor devices. In particular, a presence of dry contacts in the semiconductor device may be eliminated by the bonding processes. Further, a risk of a cover material (for example, silicone gel) penetrating into interfaces between respective components and/or a risk of oxidation of the interface between the respective components, particularly by forming insulating layers comprising oxygen, may be reduced.

Further, electric interfaces between the respective components of the semiconductor device may be reduced, thereby reducing a resistance along a current path between the top and bottom electrode-baseplates. Accordingly, an efficiency of the semiconductor device and thus the electronic power apparatus may be enhanced.

Further, a mechanical complexity of the semiconductor device may be reduced by avoiding a constructive design comprising a pressure applying element such as a spring.

Further, the semiconductor device and the electronic power apparatus may accordingly comprise a reduced package volume, particularly a reduced height (particularly by about two thirds in comparison to pressure based semiconductor devices), as compared to pressure-based semiconductor devices and electronic power apparatuses, respectively. Accordingly, the semiconductor device and the electronic power apparatus may be used in various applications areas.

Further, by manufacturing the semiconductor device based on bonding layers instead of based on the pressure applying elements such as a spring, manufacturing costs of the semiconductor device may be reduced.

Further, a limitation of a current load along the semiconductor device caused by a shape of the spring of the pressure-based semiconductor device may be avoided.

Further, since the bonding layers may represent thin elements and may directly contact adjacent layers or components, the semiconductor device may comprise an improved heat dissipation in comparison to semiconductor devices based on pressure applying elements such as a spring. In particular, the improved heat dissipation of the semiconductor device via its bottom and top electrode-baseplates may correspond to an improved inherent cooling capability of the semiconductor device being sufficient for short time heat pulses.

Further, the semiconductor device may comprise an improved internal SCFM capability provided by the first preform in combination with the semiconductor chip. In case of a failure of the semiconductor chip (for example in case of a voltage or current spike through the semiconductor chip) the material of the first preform and the material of the semiconductor device may be heated to melt such that a conductive alloy (particularly an eutectic alloy) having a lower melting temperature compared to the material of the first preform and the material of the semiconductor chip, may be formed. Accordingly, a conductive current path may be formed by the melted material of the first preform and the material of the melted semiconductor chip such that the semiconductor chip may fall into a short circuit mode. The failed semiconductor chip may not have a functionality of a switch or diode any more. However, a permanent conductive path with sufficient current carrying capability may be formed by the conductive alloy such that, owing to redundancy in the system in terms of another semiconductor chips, the respective electronic apparatus may be still operational at least for a short time. Accordingly, the lifetime of the electronic power apparatus may be prolonged despite a failure of the semiconductor chips by providing a short circuit failure mode. Further, during this short circuit mode maintenance measures may be initiated by for example, a control unit of the electronic power apparatus.

Accordingly, all issues mentioned in the section "Background Art" may be addressed by the semiconductor device, the electronic power apparatus and the method of manufacturing a semiconductor device according to the independent claims.

Next, further exemplary embodiments of the semiconductor device will be explained. However, these embodiments also apply to the electronic power apparatus, and the method of manufacturing a semiconductor device.

The semiconductor device may further comprise a second preform comprising material being configured for compensating a thermal expansion mismatch between the semiconductor chip and the first preform, wherein the second side of the first preform may be thermally and electrically connected to a first side of the second preform via a fourth bonding layer, wherein the second side of the second preform may be thermally and electrically connected to the top electrode-baseplate via the third bonding layer. In particular, an arrangement of the second preform between the semiconductor chip and the first preform may reduce stress between the material of the semiconductor chip and the material of the first preform, thereby improving a reliability of the semiconductor device.

At least one of the first and second bonding layers may be configured as silver layers such that conventional and cheap material may be used for connecting the semiconductor chip to the bottom electrode-baseplate. Further, low melting temperature alloys may be formed by a silver bonding layer in combination with the material of the semiconductor chip (particularly silicon). Thus, the SCFM capability of the semiconductor device may be improved.

The third bonding layer may be configured as a layer of solder, whereby the top electrode-baseplate and the first preform may be connected to one another by means of soldering. Thus, a cost-effective technique for connecting the respective components of the semiconductor device to one another in a mechanically stable way may be used, thereby facilitating the manufacturing of the semiconductor device.

The fourth bonding layer may be configured as a silver layer, and the third bonding layer may be configured as a layer of solder. Accordingly, in a case in which the second preform may be present in the semiconductor device, the first and second preforms may be connected to one another via a silver layer and the second preform and the top electrode-baseplate may be connected to one another by a layer of solder. Accordingly, a mechanical stability of the semiconductor device and the SCFM capability of the semiconductor device may be further enhanced by using silver and solder as bonding material, as may be explained above.

The semiconductor chip may comprise an insulated gate bipolar transistor (IGBT), a diode, a metal oxide semiconductor field effect transistor (MOSFET), a thyristor, a gate turn off (GTO) thyristor, an integrated gate commutated thyristor (IGCT), or a reverse conductive chip. Here, the term "reverse conductive chip" may particularly denote a semiconductor chip configured for operating in both freewheeling diode mode and transistor mode by utilizing the same available silicon volume in both modes such that an increase in the power density level of the semiconductor device may be accomplished. For example, a reverse conductive chip may comprise or may be configured as a bimodal insulated gate transistor (BIGT) or a reverse conductive IGBT.

The top electrode-baseplate and/or the bottom electrode-baseplate may be made of molybdenum, aluminum-graphite, copper-graphite, copper-molybdenum or any material having a coefficient of thermal expansion sufficiently close to the coefficient of thermal expansion of a semiconductor chip material (for example, silicon). Thus, a mechanical stability of the semiconductor device may be further increased, since stress during heating of the electrode-baseplates and the semiconductor chip may be reduced and the latter components may not "move" relative to one another.

The first preform may be made of aluminum-graphite (Al-graphite) or a laminate material of aluminum and molybdenum-aluminum (for example, AI/AI(AIMo)/AI). In particular, in the latter case, layers of aluminum and molybdenum-aluminum may be stacked onto one another, and/or may be sandwiched between the semiconductor chip and the top electrode-baseplate. In particular, aluminium may form a conductive alloy, particularly an eutectic alloy, in combination with the bulk material of the semiconductor device (for example, silicon). In particular, molybdenum may further comprise a coefficient of thermal expansion of about 5 ppm/K which may be close compared to the coefficient of thermal expansion of silicon (3 ppm/K) such that the mechanical stability of the semiconductor device may be improved.

The first preform may be made of aluminium, silver, gold, copper and/or magnesium, and the second preform may be made of aluminum-graphite, copper-graphite, copper-molybdenum or molybdenum (particularly having a coefficient of thermal expansion between 3 to 8 ppm/K). In addition to the above described technical effects, these materials may represent cost-effective and easily processible materials when designing the first and second preforms.

In particular, in a case, in which the first preform comprises aluminium-graphite, the aluminium-graphite may comprise an aluminium skin or outer surface portion of the first (bulk) preform which may increase an amount of aluminium of the alloy formed when heat impacts the first preform in a failure event. Accordingly, the alloy formed by the first preform and the semiconductor chip may be further improved.

An aluminium foil may be arranged between the bottom electrode-baseplate and the bottom electrode of the semiconductor chip, which may allow for providing additional aluminium from a bottom side of the semiconductor chip for the creation of the conductive alloy. Thus, the conductive path over or through the semiconductor chip may be improved, thereby further improving a short circuit mode of the semiconductor device.

In particular, a lower side of the aluminium foil may be connected to the bottom electrode-baseplate via a ((silver) sintered) bonding layer, and the upper side of the aluminium foil may be connected to the bottom electrode of the semiconductor chip by another ((silver) sintered) bonding layer. Accordingly, manufacturing of the semiconductor device may be facilitated in that a conventional connection technique may be used for connecting various components of the semiconductor device to one another. In particular, in a case in which all bonding layers may realized by sintering, the method may be further facilitated in that one common connection technique may be employed.

The semiconductor chip may be embedded in silicone gel. This silicone gel may provide a protection of the semiconductor chip against its environment and may provide an electrical insulation of the semiconductor chip. In particular, the silicone gel may fill up open spaces of a housing of the semiconductor device.

In particular, the semiconductor device may comprise a package casing or package housing which may withstand the failure event and the formation of the alloy as described above, since temperature caused by the failure event and impacting the semiconductor device may be dissipated over the housing to the environment. In particular, the package may also be configured for withstanding an overpressure which may develop in the semiconductor device owing to the failure event of the semiconductor chip.

The bottom electrode-baseplate and/or the top electrode-baseplate may be configured for being cooled (particularly by a water cooling system or an air cooling system) such that a double-side cooled semiconductor device comprising SCFM capability may be provided. Accordingly, a higher switching power per semiconductor chip material area may be provided owing to the cooling of the top electrode-baseplate and the bottom-electrode base plate. Further, a number of used semiconductor devices in the electronic power apparatus may be reduced. Further, since the semiconductor chip may be connected to the top and bottom electrode-baseplates by bonding, the semiconductor chip may be connected to two large thermal masses such that heat pulses may be effectively buffered by thermal capacitances of the top and bottom electrode-baseplates. Accordingly, a cooling system connected to the top and bottom electrode-baseplates may be designed in a less efficient way, thereby further reducing costs.

In particular, the bottom electrode-baseplate, the top electrode-baseplate, the semiconductor chip, the first preform and/or the second preform may comprise a surface layer which may be, for example, formed by electroplating and may serve for protecting a surface of the respective component against damages and/or to reduce electrical resistance. Accordingly, a respective bonding layer is formed between the surface layer of the component and an adjacent component.

In particular, the semiconductor device may further comprise an at least another semiconductor chip (or a plurality of another semiconductor chips) which is (or are) connected to the bottom electrode-baseplate and the top electrode-baseplate in a similar way as described above with respect the semiconductor chip. In particular, one or more of the above described measures and technical effects may apply to such a semiconductor device.

In particular, the semiconductor chips of one or more of the semiconductor devices may be connected in parallel to one another.

Next, further exemplary embodiments of the electronic power apparatus will be explained. However, these embodiments also apply to the semiconductor device and the method of manufacturing a semiconductor device.

In particular, the electronic power apparatus may comprise a plurality of semiconductor devices each of which comprising one or more semiconductor chips. The semiconductor chips of one or of more semiconductor devices may be connected in parallel to one another, and the semiconductor devices may be connected in series to one another. Accordingly, in a case of a failure of one of the semiconductor chips of one of the semiconductor devices, the other semiconductor devices may provide a current switching or current blocking capability of the electronic power apparatus.

In particular, the semiconductor devices may be stacked above one another such that the electronic power apparatus may comprise a compact design.

The electronic power apparatus may be configured as a direct current (DC) circuit breaker apparatus. Accordingly, by designing the semiconductor device of the DC circuit breaker apparatus with a SCFM capability, the DC circuit breaker apparatus may be operable despite a failure event of one of its semiconductor devices. In particular, since the semiconductor device may represent a large amount of the manufacturing costs of the DC circuit breaker apparatus, reducing the manufacturing costs of the DC circuit breaker apparatus by about more than 50 per cent in comparison to a DC circuit breaker apparatus comprising pressure based semiconductor devices may be accomplished. Further, in a case of an electronic power apparatus comprising a plurality of semiconductor devices (for example, 100 semiconductor devices) being connected in series to one another and being stacked, the reduced height of the semiconductor devices (in comparison to the pressure based semiconductor device) may cause the electronic power apparatus to comprise a compact shape.

In particular, in a case in which the DC breaker circuit apparatus may comprise BIGTs, the DC breaker apparatus may be usable in High Voltage DC (HVDC) transmission networks. In particular, a lifetime of the short circuit mode of the DC circuit breaker apparatus may be sufficiently long even being shorter in comparison to a lifetime of a short circuit mode of a pressure based semiconductor device or electronic power apparatus.

In particular, the electronic power apparatus may comprise a bypassing functionality configured for bypassing a failed semiconductor device and thus may provide another short circuit functionality of the electronic power apparatus, thereby prolonging the lifetime of a failed semiconductor device and the respective short circuit mode of the electronic power apparatus. This functionality may be executed timely parallel with respect to the short circuit mode of the failed semiconductor device. In particular, the bypassing functionality may comprise a switching unit being electrically connected in parallel to semiconductor devices of the electronic power apparatus or in parallel to the electronic power apparatus. Thus, the switching unit may either form part of the electronic power apparatus or may be embodied as a separate unit. In particular, the switching unit may be mechanically operated using, for example, hydraulically generated pressure, or may be electrically operated. In case of an electrically operated switching unit, the switching unit may be embodied as a controllable relay.

In particular, in a case in which the electronic power apparatus may comprise semiconductor devices comprising semiconductor chips in the form of transistors, the bypassing functionality may comprise a driving gate unit configured for permanently switching on the another semiconductor devices distinct of the failed semiconductor device such that a current may be distributed along all semiconductor devices instead of only along the failed semiconductor device. Thus, a lifetime of the failed semiconductor device may be prolonged. The latter described bypassing functionality may similarly apply to semiconductor devices comprising diodes.

Next, further exemplary embodiments of the method of manufacturing a semiconductor device will be explained. However, these embodiments also apply to the semiconductor device and the electronic power apparatus.

The method may further comprise providing a second preform made of material being configured for compensating a thermal expansion mismatch between the semiconductor chip and the first preform, and bonding (particularly sintering) the second preform to the stack. Accordingly, this measure and the accordingly manufactured semiconductor device may comprise the above described technical effects and advantages.

In particular, an aluminum foil may be connected to the bottom electrode-baseplate and the semiconductor chip by bonding, particularly by (silver) sintering.

In particular, the sintering may comprise low temperature bonding (LTB) or nanosintering, thereby facilitating the method by using conventional bonding techniques.

In particular, the bottom electrode-baseplate, the semiconductor chip, and the first preform may be bonded, particularly sintered, to one another in one step particularly using a respective fixture tool. Thus, the manufacturing process may be speeded up.

In particular, the first and/or second preforms may be bonded, particularly sintered, to the semiconductor chip, and afterwards the semiconductor chip including the first and/or second preforms may be bonded, particularly sintered, to the bottom electrode-baseplate. Accordingly, a relative arrangement of the fragile semiconductor chip and the first and/or second preforms may be firstly set before connecting the semiconductor chip to the bottom electrode-baseplate.

In particular, the first and/or second preforms may be bonded, particularly sintered, to one another, and afterwards to the semiconductor chip particularly using a subsequent bonding step, particularly sintering step, whereby contamination of the semiconductor chip edges may be prevented which may occur when bonding, particularly sintering, the combined first and second preforms to the semiconductor chip.

In particular, a sequence of bonding the bottom electrode-baseplate, the semiconductor chip, the first preform, the second preform, and/or the aluminium foil to one another may be arbitrarily.

In particular, the sintered bonding layers between the respective components of the semiconductor device may be configured for being withstanding short circuit events in that a degree of strength of the sintered bonding layers between the respective components of the semiconductor device may be sufficiently strong.

In particular, the semiconductor device may be configured for withstanding a transition event during which a short circuit of one semiconductor device may propagate from one semiconductor chip to another semiconductor chip. In a case in which the semiconductor device may comprise at least two semiconductor chips, the short circuit may propagate along the failed semiconductor chip device and eventually may move to another semiconductor device of the electronic power apparatus.

In particular, since the semiconductor device may comprise a compact shape, cooling of the semiconductor chips may be improved, thereby reducing the heat impact on the semiconductor devices during the operation and supporting to prevent failure events.

### Brief description of drawings

The invention will be described in more detail hereinafter with reference to examples of embodiment, but to which the invention is not limited.

Figures 1 to 4 show perspective views of steps of a method of manufacturing a semiconductor device according to an exemplary embodiment of the invention.

Figure 5 shows a schematic cross-sectional view of an electronic power apparatus according to an exemplary embodiment of the invention.

Figure 6 shows an enlarged view of a semiconductor device of the electronic power apparatus of Figure 5.

Figure 7 shows semiconductor devices of a DC circuit breaker apparatus according to another exemplary embodiment of the invention.

### Description of embodiments

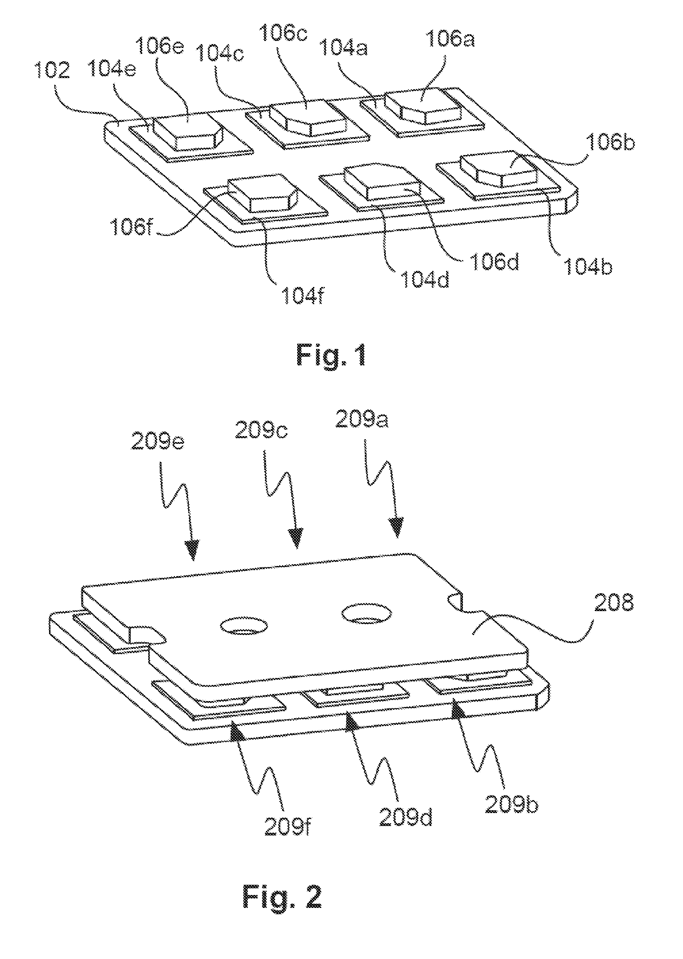

Referring to Figures 1 to 4, a method of manufacturing a semiconductor device of an electronic power apparatus according to an exemplary embodiment of the invention will be explained. The electronic power apparatus is usable in high power applications, and is configured for withstanding heat impacted failure of one of its semiconductor devices such that an operation of the electronic power apparatus is maintained despite of the failure of the one of its semiconductor devices.

In a first step of the method, a bottom electrode-baseplate 102, a plurality of semiconductor chips 104a-f, and a plurality of preforms 106a-f are provided. The bottom electrode-baseplate 102 is made of copper-molybdenum. A part of the semiconductor chips 104a-f of the plurality of semiconductor chips 104a-f are configured as switching components in the form of silicone based IGBTs and another part of the semiconductor chips 104a-f of the plurality of semiconductor chips 104a-f are configured as free-wheeling diodes. Further, the preforms 106a-f of the plurality of preforms 106a-f are identically designed with respect to one another, and are made of aluminium-graphite.

A bottom electrode of each of the semiconductor chips 104a-f of the plurality of semiconductor chips 104a-f is bonded to a respective upper side of the bottom electrode-baseplate 102 using a silver sintering process. Accordingly, a first silver bonding layer is formed between the upper side of portions of the bottom electrode-baseplate 102 and the respective lower electrode of each of the semiconductor chips 104a-f. Next, an upper electrode of each of the semiconductor chips 104a-f is sintered to a lower side of a respective one of the preforms 106a-f. A used sinter material is made of silver. Accordingly, a second silver bonding layer is formed between the upper electrode of the semiconductor chips 104a-f and the lower side of the preforms 106a-f.

Next, in a subsequent method step illustrated in Figure 2, a top electrode-baseplate 108 made of copper-graphite is soldered to the upper sides of the preforms 106a-f such that a third soldered bonding layer is formed between each of the preforms 106a-f and respective portion of the top electrode-baseplate 208. Accordingly, semiconductor devices 209a-f are formed each of which comprising a single semiconductor chip 104a-f.

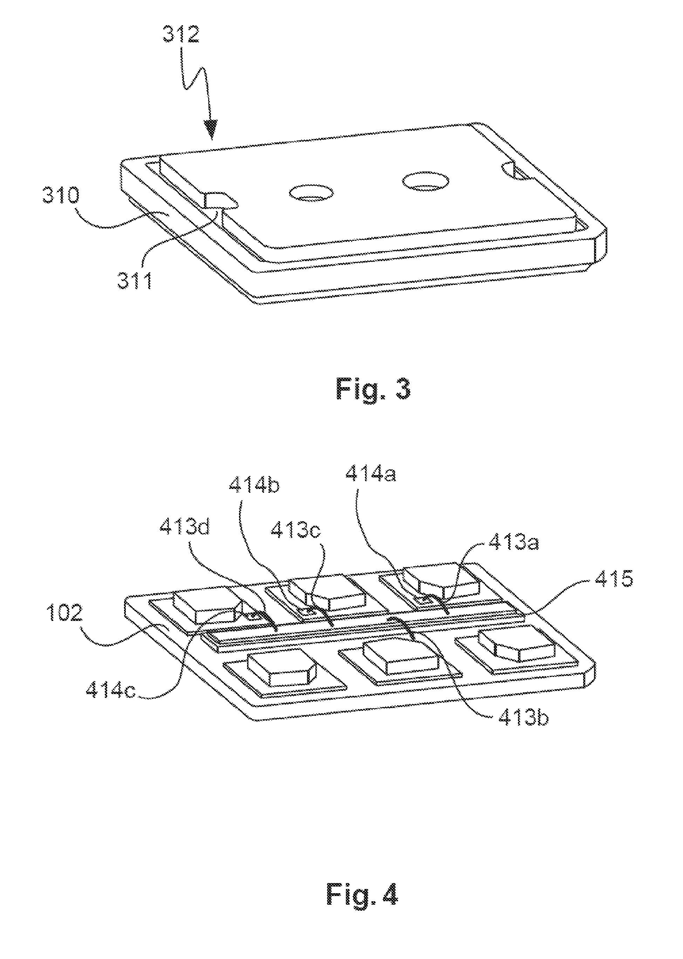

Next, in a subsequent method step illustrated in Figure 3, a rectangularly shaped, framed housing 310 is attached to the circumference of the upper surface of the bottom electrode-baseplate 102. An upper inner surface portion of an inner surface of the housing 310 abuts against lateral sides of the top electrode-baseplate 208. Further, silicone gel 311 is inserted in a space formed between the bottom electrode-baseplate 102, the top electrode-baseplate 208 and the housing 310 such that the semiconductor chips 106a-f are embedded in the silicone gel 311.

Next, a plurality of the above described units comprising the semiconductor devices 209a-f arranged in the housing 310 and covered by the silicone gel 311 are manufactured and are stacked above one another. The semiconductor devices of one unit are connected in parallel to one another, and the plurality of units are connected in series to one another. Thus, the electronic power apparatus, now referenced by a reference numeral 312, is manufactured.

Figure 4 shows an intermediate method step which is executed between the method step illustrated in Figure 1 and the method step illustrated in Figure 2. Here, respective bonding wires 413a-d are attached to gate contacts 414a-c of the semiconductor chips 106a, c, d, e and to a conductive lead 415 which is arranged along a longitudinal extension of the bottom electrode-baseplate 102 between the semiconductor chips 106a, c, e and the semiconductor chips 106b, d, f. The conductive lead 415 forms part of an electrical connection to the gate contacts 414a-c of the semiconductor chips 104a-f from auxiliary terminals used for a control of the semiconductor devices 209a-f. It is noted that the auxiliary terminals are not shown in Figure 4. Although only four bonding wires 413a-d are shown in Figure 4 for illustration purposes, a suitable number of bonding wires are attached to the respective gate contacts of the semiconductor chips 104a-f such that the semiconductor chips 104a-f of the assembled electronic power apparatus 312 are electrically connected in parallel to one another.

Further, the method may comprise a step of silver sintering an aluminium foil to the upper side of the bottom electrode-baseplate 102 prior to connecting the semiconductor chips 104a-f to the bottom electrode-baseplate 102. The aluminium foil may extend along an entire surface of the bottom electrode-baseplate 102, and may be present between connection regions of the semiconductor chips 104a-f to the bottom electrode-baseplate 102.

Prior to operation of the electronic power apparatus 312, the bottom and top electrode-baseplates 102, 208 are connected to a water cooling system such that the bottom electrode-baseplate 102 and the top electrode-baseplate 208 may be cooled, in order to improve the operation performance of the electronic power apparatus 312. Gate voltages are applied to respective gate contacts of the semiconductor chips 104a-f of the semiconductor devices 209a-f. Afterwards, electric current is applied to the bottom electrode-baseplate 102 such that a current is transferred to the top electrode-baseplate 208 via each of the semiconductor devices 209a-f.

In the following, a failure event of the electronic power apparatus 312 will be described. In such an incidence, one of the semiconductor devices 106a-f is impacted by a heat impulse caused by, for example, a cosmic ray event or a flash-over between respective portions of the bottom electrode-baseplate 102 and the top electrode-baseplate 108. In the following, it is assumed for explanation purposes that the semiconductor chip 104a is affected by such a heat impact and the semiconductor chip 104a comprises an IGBT. The heat is transferred to the material of the preform 106a and the bulk material of the semiconductor chip 104a such that an electrically conductive alloy or even eutectic alloy starts to form at an interface between the upper side of the semiconductor chip 104a and the lower side of the preform 106a. A respective melting process results in an electrically conductive channel through the semiconductor chip 104a, whereby a stable short circuit of the semiconductor device 109a is caused. Accordingly, the IGBT of the semiconductor chip 104a is permanently switched on such that a switching function of the electronic power apparatus 111 will be provided by the not affected semiconductor chips of the semiconductor devices of the other units of the electronic power apparatus 312. Thus, a continuous operation of the electronic power device 312 is provided.

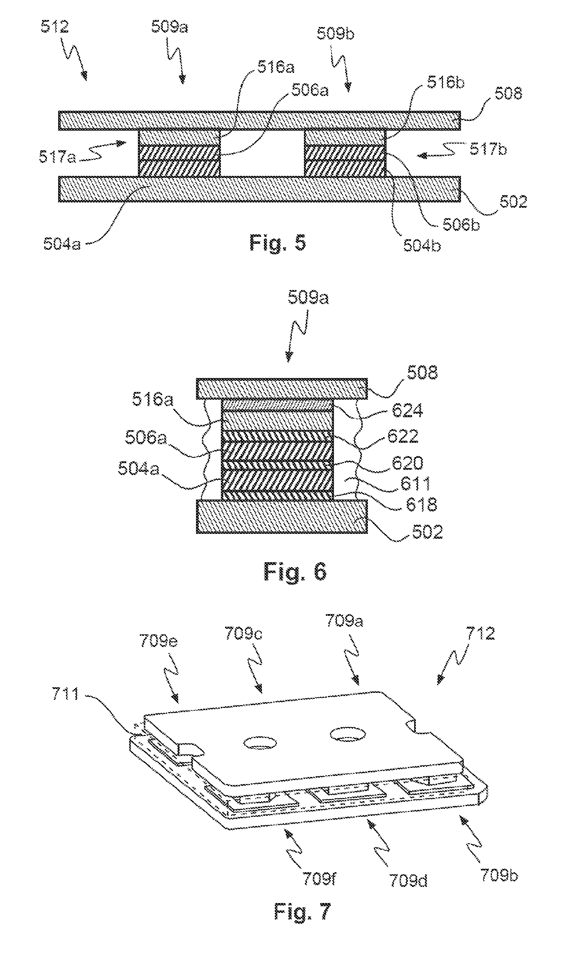

Referring to Figures 5 and 6, an electronic power apparatus 512 according to another exemplary embodiment of the invention will be explained.

The electronic power apparatus 512 comprises a bottom electrode-baseplate 502 and a top electrode-baseplate 508 both made of molybdenum. A plurality of silicon based semiconductor chips 504a, b, a respective plurality of first preforms 506a, b made of aluminium and a plurality of second preforms 516a, b made of molybdenum are sandwiched between the bottom electrode-baseplate 502 and the top electrode-baseplate 508 and form respective stacks 517a, b. A first silver bonding layer 618 is sintered between the bottom electrode-baseplate 502 and the lower electrode of the semiconductor chip 504a (Figure 6). A second silver bonding layer 620 is sintered between the upper electrode of the semiconductor chip 504a and the lower side of the first preform 506a. A third silver bonding layer 622 is sintered between the upper side of the first preform 506a and the lower side of the second preform 516a. Further, a layer 624 of solder is soldered between the upper side of the second preform 516a and the lower side of the top electrode-baseplate 508. Afterwards, the semiconductor chips 509a, b are embedded in silicone gel 611.

In addition to the semiconductor devices 209a-f described with reference to Figures 1 to 4, the semiconductor device 509a comprises a further improved mechanical stability and reliability, since a coefficient of thermal expansion of the second preform 516a is close to a coefficient of thermal expansion of the silicon material of the semiconductor chip 506a.

A respective method of manufacturing the semiconductor device 509a is described in the following. First, the bottom electrode-baseplate 502, the semiconductor chips 504a, b, the first preforms 506a, b, and the second preforms 516a, b are stacked onto one another. The latter components are then sintered to one another in one sintering step using the silver sintering materials. Alternatively, the components are sintered to one another in subsequent sintering steps. Alternatively, the bottom electrode-baseplate 502 is sintered to the semiconductor chips 509a, b, and afterwards, in one sintering step, the first and second preforms 506a, b, 516a, b are sintered to one another and to the semiconductor chip 506a, b, respectively.

Referring to Figure 7, semiconductor devices 709a-f of a DC circuit breaker apparatus 712 according to an exemplary embodiment of the invention is shown. The DC breaker apparatus 712 comprises a mechanical disconnecting device, a small switching device, and a plurality of identically designed units each one which comprising the semiconductor devices 709a-f. The units are stacked above one another and are connected in series to one another. The mechanical disconnecting device and the small switching device are arranged in series and in a bypass line bypassing the plurality of units. The small switching device is identically constructed compared to the semiconductor devices 509a, b illustrated in Figures 5 and 6, and the semiconductor devices 709a-f are similarly constructed compared to the semiconductor devices 209a-f of the electronic power apparatus 312 illustrated in Figures 1 to 4. However, the semiconductor chips of the semiconductor devices 709a-f comprise BIGTs instead of the IGBTs which are embedded in silicone gel 711.

During operation of the DC circuit breaker apparatus 712, the top and bottom electrode-baseplates of the small switching device are cooled using an air cooling device, whereas top and bottom electrode-baseplates 702, 708 of the semiconductor devices 709a-f are not cooled. Current is transferred via the bypass line comprising the mechanical switching device and the small switching device. At an instance, the units are controlled to switch the DC circuit breaker apparatus 712, and current is transferred via the units and thus the semiconductor devices 709a-f for about 10 milliseconds. Accordingly, an inherent cooling capability of the semiconductor devices 709a-f is sufficient, since a time of the current transfer via the semiconductor devices 709a-f is extremely short. During a failure of one semiconductor chip of one of the semiconductor devices of one unit, the respective semiconductor device is short circuited, as is described above in connection with Figures 1 to 4. Thus, a switching capability of the DC circuit breaker apparatus 712 is provided by the other units electrically connected in series to the failed unit.

According to another exemplary embodiment, all the issues mentioned above (particularly in the section "Background Art") are addressed in the presented invention. The invention here is on a concept of a power module with internal SCFM capability without dry contacts and mechanical components developing high pressure and with double side cooling of chips in the module.

The proposed module basically consists of two electrically conductive plates between which the semiconductor chips and, directly above or below the chips, additional elements are placed. These additional elements are able to form a eutectic alloy together with silicon. To attach adjacent parts, joining methods such as soldering, brazing or sintering (etc.) are used. In an application is the module sandwiched between two coolers which also serve as positive and negative electrodes.

It has been shown experimentally that in such a structure, a SCFM is formed after a chip failure. The SCFM has been shown to possess a certain lifetime, at least several seconds. During this period, the failure (short circuit) could be detected and the control system could switch on a more reliable switch than a melted chip in the module. Such an approach could open the door for a new generation of considerably less expensive modules with SCFM capability; however, probably limited short circuit transition capability.

Summarizing, the advantages of the described package are: 1. Lower material and production cost than for a StakPak; 2. Higher switching power per silicon area due to the improved cooling; 3. Less package volume (in particular: less height); 4. High reliability under normal operation conditions (no dry contacts, CTE-matched materials, low chip temperature ripples due to large thermal masses directly attached to the chip); 5. SCFM capability.

Preferred embodiments may be as follows.

In a first embodiment (1. embodiment), the semiconductor device includes a semiconductor chip, a bottom electrically and thermally conductive electrode-baseplate, a top electrically and thermally conductive electrode-baseplate, a preform made of material supporting creation of spot in a case of a failure (creation of eutectic alloy with Si with lower melting temperature).

The bottom electrode of the semiconductor chips is thermally and electrically connected to the bottom electrode-baseplate via a bonding layer. The top electrode of the semiconductor chip is thermally and electrically connected to the preform via a bonding layer. The other side of the preform is thermally and electrically connected to the top electrode-baseplate via a bonding layer.

An example of a small module based on this structure is shown in Figures 1 to 4.

In a second embodiment (2. embodiment), the semiconductor device includes a semiconductor chip, a bottom electrically and thermally conductive electrode-baseplate, a top electrically and thermally conductive electrode-baseplate, a first preform made of material supporting creation of spot in a case of a failure (creation of eutectic alloy with Si with lower melting temperature), a second preform made of material compensating CTE mismatch between a semiconductor chip and the first preform.

The bottom electrode of the semiconductor chips is thermally and electrically connected to the bottom electrode-baseplate via a bonding layer. The top electrode of the semiconductor chip is thermally and electrically connected to the first preform via a bonding layer. The other side of the first preform is thermally and electrically connected to the second preform via a bonding layer. The other side of the second preform is thermally and electrically connected to the top baseplate via a bonding layer.

A schematic picture of such structure is shown in Figures 5 and 6.

Further embodiments of the semiconductor devices may be as follows.

A 3. embodiment may relate to a device as described in the 1. and/or 2. embodiment, wherein the bottom electrode of the semiconductor is bonded to the bottom baseplate via a silver layer.

A 4. embodiment may relate to a device as described in the 1. and/or 2 embodiment, wherein the first preform is bonded to the top electrode of the chip via a silver layer.

A 5. embodiment may relate to a device as described in the 2 embodiment, wherein the second preform is bonded to the first preform via a silver layer.

A 6. embodiment may relate to a device as described in the 1. and/or 2. embodiment, wherein the top electrode is bonded to the preform one or two via a layer of solder.

A 7. embodiment may relate to a device as described in one of the previous embodiments, wherein the semiconductor chips are e.g. IGBTs, diodes, reverse conductive chips.

A 8. embodiment may relate to a device as described in one of the previous embodiments, wherein the baseplates could be made of Molybdenum, Al-graphite, Cu-graphite, Cu-molybdenum etc. (materials with CTE close enough to silicon).

A 9. embodiment may relate to a device as described in the 1 embodiment, wherein the preform is made of e.g. Al-graphite.

A 10. embodiment may relate to a device as described in 1 embodiment, wherein the preform is made of laminate material (sandwich) - Al/Mo(AlMo)Al.

A 11. embodiment may relate to a device as described in the in 2. embodiment, wherein the first preform is made of Aluminium, Silver, Gold;
The second preform is made of Algraphite, Cu-graphite, Cu-moly, Molybdenum (CTE = 3-8).

A 12. embodiment may relate to a device as described in 8. and/or 9. embodiment, wherein Al-graphite has an Aluminium skin increasing amount of Aluminium available for hot spot.

A 13. embodiment may relate to a device as described in the 1. and/or 2. embodiment, wherein there is Al foil between the bottom baseplate and the bottom electrode of the chip.

A 14. embodiment may relate to a device as described in the 13 embodiment, wherein there is a silver layer between the bottom baseplate and Al foil and there is another silver layer and between Al-layer and chips - Al layer is bonded on baseplate and chips are bonded on Al layer.

A 15. embodiment may relate to a device as described in one of the previous embodiments, wherein the chips are embedded in silicone gel bringing sufficient electrical isolation.

A 16. embodiment may relate to a device as described in one of the previous embodiments, wherein the substrate for a gate connection, surface of components (e.g. gold plating etc) can be also defined in additional dependant claims.

A 17. embodiment may relate to a device as described in one of the previous embodiments, wherein the structure has a package-case withstanding the failure event and formation of the hot spot.

In a 18. embodiement (method), the stack - bottom substrate, chip and preform is prepared by the silver sintering process (eventually also Al foil from 13) and the top electrode of the module is bonded using soldering.

In a 19. embodiment (method), the stack - bottom substrate, chip, first and second preform is prepared by the sintering process (eventually also Al foil from 13) and the top substrate is bonded using soldering.

A 20. embodiment may relate to the method as described in the 18 or 19 embodiment, wherein sintering can be LTB (low-temperature bonding) or nanosintering.

A 21. embodiment may relate to the method as described in one of the embodiment 18 to 20, wherein all components can be sintered in one step using fixture.

A 22. embodiment may relate to the method as described in one of the embodiment 18 to 21, wherein preforms can be sintered on the chips and afterwards the chips with preforms sintered to the bottom electrode.

A 23. embodiment may relate to the method as described in one of the embodiment 19 to 22, wherein preforms are sintered together and than bonded to chip surface in the next sintering step (less contamination of chip edges).

Additional remarks regarding the embodiments may be as follows:

Sintered bonds should be sufficiently strong to withstand SC event.

The presspack module should be in principle able to handle a transition event.

The press-pack is very compact - this improves cooling of chips.

Double-side cooled power module with SCFM capability may be described.

A double-side cooled module of press-pack type with an internal short circuit failure mode capability is presented. Bonding technologies which only recently got more attention in power electronics in a combination with CTE (coefficient of thermal expansion) matched emitter and collector baseplates are proposed for its fabrication. This approach should allow fabrication of very compact and relatively simple modules without internal dry contacts suitable especially for multilevel converter topologies applied in a power transmission area.

In the following, reference between the above described first and second embodiments (and the further embodiments) and the Figures may be presented.

Figures 1 to 4 are showing an example of a small double side cooled module with SCFM capability according to the 1. embodiment. This module was designed with the aim to check feasibility of the concept. Figure 1: A bottom electrode with bonded chips and preforms supporting SCFM - hot spot formation. Materials of preform and chip form a eutectic alloy with a low-melting temperature. CTE of preform and chip is sufficiently close. Figure 2: A top electrode was bonded to the top contact of the chip. Figure 3: The finalized module with a case. Figure 4: An example of a possible gate wiring of the module.

Figures 5, 6 may show a schematic cross-section and a detailed of a part of a power module with SCFM capability according to the 2. embodiment. The collector side of a chip is bonded to CTE reasonably matched bottom electrode (e.g. Molybdenum) for example by sintering. The component made of metal suitable for SCFM capability (e.g. Aluminium) is sintered on the emitter side of the chip. In the same or the next sintering step another preform is bonded on the other side of the first preform. The second preform has CTE close to Silicon. In the final step the top electrode is soldered to the second preform.

Another exemplary embodiment refers to a DC Circuit Breaker containing double-side cooled BIGT packages.

A background for this embodiment may be as follows.

DC Circuit Breakers containing IGBT and diodes as conducting / blocking elements show potential to be used in future HVDC transmission networks. Particularly promising properties are achievable using BIGT chips instead of the IGBT / diode combination since here, the health of the IGBTs and diodes can be monitored via the BIGT's gate.

For the DC circuit breaker proposed the capability of the BIGT package to fall into a short-circuit after e.g. a chip failure is required. However, the short-circuit mode does not need to possess a long lifetime since the chips are activated only for a short time during a switching event (total required short-circuit lifetime within 30 years: > 10 s).

A problem may be as follows.

Currently, StakPak packages are equipped with IGBT chips for operation in DC circuit breakers. However, these packages are overdesigned and bring in disadvantages for this application:

The StakPak construction is designed for a long short-circuit lifetime and is hence a complex and expensive construction. The cost of the StakPak modules significantly contributes to the whole DC circuit breaker cost.

In a StakPak, the chips are attached to a relatively low thermal mass (Moly base plate at the bottom side of the chips). This means that a transient heat load is not buffered optimally.

Furthermore, due to the low thermal mass attached to the chips, the maximum duration of a high current pulse (e.g. 8-10 kA) through the chips is limited.

The embodiment may be described as follows.

These disadvantages can be overcome by using double-side cooled BIGT packages in the DC circuit breaker. Such a double-side cooled package basically consists of one or several BIGT chips which are sandwiched between two electrically conductive plates to which the chips are attached. Besides the top and bottom plates, additional components (such as spacer layers) could be included.

Recent experiments have shown that when such a package has Al adjacent to the Si chips, an electrically conductive alloy is formed in the case of a failure, i.e. the package is short-circuited, as required by the application. However, the lifetime of this short-circuit mode is shorter than that of the StakPak but still fully sufficient to meet the requirements of DC circuit breakers (shortest measured short-circuit lifetime of a non-optimized package: several minutes). Hence, double-side cooled packages with such a short-term short-circuit capability can be used for this application.

To reduce the risk of a too short lifetime, the package can be combined with some other short-circuit functionality that could e.g. be triggered by the driving gate unit.

This invention combines several novel technologies (double-side cooled packages, BIGT chips, transistor-based DC circuit breaker) to obtain a substantial cost and/or performance improvement of DC circuit breakers.

A business benefit may be as follows.

1. The package itself is significantly cheaper than the StakPak due to its simple construction. Since the semiconductor packages represents a large amount of the total DC circuit breaker cost (> 50% (70%), depending what you include in the costs) the cost of the entire circuit breaker can be significantly reduced.

2. Compared to a StakPak, due to the improved thermal properties of double-side cooled packages, the same performance (e.g. current carrying capability for a specified duration) can be obtained using a smaller number of semiconductor chips (or modules). This further reduces cost.

3. In a double-side cooled package, two large thermal masses (e.g. two Moly plates) are directly attached to the two main surfaces of the chip by e.g. a soldered or sintered connection. Transient heat pulses in the chips will be more effectively buffered by the thermal capacitances of the plates in direct vicinity to the chips. Since the chips only generate heat for a very short time in a DC circuit breaker, an active cooling system (e.g. water cooling) can be designed less powerful - or might even become obsolete. This saves further cost.

4. The double-side cooled packages are very flat compared to the StakPak (approx. 2/3 lower package height). If a large number of packages (e.g. 100) is connected in series, this lower package height saves a lot of space (several meters when summing up all the package heights) making the whole DC circuit breaker construction more compact.

An example of this embodiment may be shown in Figure 7.

### Reference signs list

- 102, 502: bottom electrode-baseplate
- 104a-f, 504a, b: semiconductor chip
- 106a-f, 506a, b: first preform
- 208, 508: top electrode-baseplate
- 209a-f, 509a, b, 709a-f: semiconductor device
- 310: housing
- 311, 611, 711: silicone gel
- 312, 512, 712: electronic power apparatus
- 413a-d: bonding wires
- 414a-c: gate contact
- 415: conductive lead
- 516a, b: second preform
- 618: first bonding layer
- 620: second bonding layer
- 622: third bonding layer
- 624: fourth bonding layer

## Claims

1. A semiconductor device (209a-f, 509a, b, 709a-f), the semiconductor device (209a-f, 509a, b, 709a-f) comprising:
- a semiconductor chip (104a-f, 504a, b) comprising a bottom electrode and a top electrode;
- a bottom electrode-baseplate (102, 502), wherein the bottom electrode-baseplate (102, 502) is electrically and thermally conductive;
- a top electrode-baseplate (108, 508), wherein the top electrode-baseplate (108, 508) is electrically and thermally conductive; and
- a first preform (106a-f, 506a, b) made of material configured for supporting a creation of an electrically conductive alloy when being melted,
wherein the bottom electrode of the semiconductor chip (104a-f, 504a, b) is thermally and electrically connected to the bottom electrode-baseplate (102, 502) via a first bonding layer (618), wherein the top electrode of the semiconductor chip (104a-f, 504a, b) is thermally and electrically connected to a first side of the first preform (106a-f, 506a, b) via a second bonding layer (620), and wherein the second side of the first preform (106a-f, 506a, b) is thermally and electrically connected to the top electrode-baseplate (108, 508) via a third bonding layer (624).

2. The semiconductor device (209a-f, 509a, b, 709a-f) according to claim 1, the semiconductor device (509a, b) further comprising:
- a second preform (516a, b) comprising material being configured for compensating a thermal expansion mismatch between the semiconductor chip (104a-f, 504a, b) and the first preform (506a, b),
wherein the second side of the first preform (506a, b) is thermally and electrically connected to a first side of the second preform (516a, b) via the fourth bonding layer (622), wherein the second side of the second preform (516a, b) is thermally and electrically connected to the top electrode-baseplate (508) via the third bonding layer (624).

3. The semiconductor device (209a-f, 509a, b, 709a-f) according to claim 1 or 2, wherein at least one of first and second bonding layers (618, 620) are configured as silver layers.

4. The semiconductor device (209a-f, 509a, b, 709a-f) according to anyone of claims 1 to 3, wherein the third bonding layer (624) is configured as a layer of solder.

5. The semiconductor device (509a, b) according to anyone of claims 2 to 4,
wherein the fourth bonding layer (622) is configured as a silver layer, and the third bonding layer (624) is configured as a layer of solder.

6. The semiconductor device (209a-f, 509a, b, 709a-f) according to anyone of claims 1 to 5, wherein the semiconductor chip (104a-f, 504a, b) comprises an insulated gate bipolar transistor, a diode, a metal oxide semiconductor field effect transistor, a thyristor, a gate turn off thyristor, an integrated gate commutated thyristor or a reverse conductive chip.

7. The semiconductor device (209a-f) according to anyone of claims 1, 3, 4 or 6, wherein the first preform (106a-f) is made of aluminum-graphite or a laminate material of aluminum and molybdenum-aluminum.

8. The semiconductor device (509a, b) according to anyone of claims 2, 3, 5, or 6, wherein the first preform (506a, b) is made of aluminum, silver, gold, copper and/or magnesium, and wherein the second preform (516a, b) is made of aluminum-graphite, copper-graphite, copper-molybdenum or molybdenum.

9. The semiconductor device (209a-f, 509a, b, 709a-f) according to anyone of claims 1 to 8, wherein an aluminum foil is arranged between the bottom electrode-baseplate (102, 502) and the bottom electrode of the semiconductor chip (104a-f, 504a, b).

10. The semiconductor device (209a-f, 509a, b, 709a-f) according to anyone of claims 1 to 9, wherein the semiconductor chip (104a-f, 504a, b) is embedded in silicone gel (311,611,711).

11. The semiconductor device (209a-f, 509a, b, 709a-f) according to anyone of claims 1 to 10, wherein the bottom electrode-baseplate (102, 502) and/or the top electrode-baseplate (108, 508) are configured for being cooled.

12. An electronic power apparatus (312, 512, 712), the electronic power apparatus (312, 512, 712) comprising a semiconductor device (209a-f, 509a, b, 709a-f) according to anyone of claims 1 to 11.

13. The electronic power apparatus (312, 512, 712) according to claim 12, wherein the electronic power apparatus (312, 512, 712) is configured as a direct current circuit breaker apparatus.

14. A method of manufacturing a semiconductor device (209a-f, 509a, b, 709a-f), the method comprising:
- Providing a semiconductor chip (104a-f, 504a, b) comprising a bottom electrode and a top electrode;
- providing a bottom electrode-baseplate (102, 502), wherein the bottom electrode-baseplate (102, 502) is electrically and thermally conductive;
- providing a top electrode-baseplate (108, 508), wherein the top electrode-baseplate (108, 508) is electrically and thermally conductive;
- providing a first preform (106a-f, 506a, b) made of material configured for supporting a creation of an electrically conductive alloy when being melted;
- preparing a stack (517a, b) of the bottom electrode-baseplate (102, 502), the semiconductor chip (104a-f, 504a, b), and the first preform (106a-f, 506a, b) by bonding; and
- bonding the top electrode-baseplate (108, 508) to the stack (517a, b).

15. The method according to claim 14, the method further comprising:
- Providing a second preform (506a, b) made of material being configured for compensating a thermal expansion-mismatch between the semiconductor chip (504a, b) and the first preform (506a, b), and
- bonding the second preform (516a, b) to the stack (517a, b).
